# EUROPÄISCHE PATENTSCHRIFT

(11) **EP 3 879 280 B1**
(45) Veröffentlichungstag und Bekanntmachung des Hinweises auf die Patenterteilung: **19.07.2023**
(21) Anmeldenummer: 21161283.3
(22) Anmeldetag: 08.03.2021
(51) Int. Cl.: G01R 27/16, G01R 31/08, G01R 31/52

(54) **VERFAHREN ZUR MESSUNG DER ERDSCHLEIFENIMPEDANZ**
METHOD FOR MEASURING GROUND LOOP IMPEDANCE
PROCÉDÉ DE MESURE DE L'IMPÉDANCE DE REBOUCLAGE DU CIRCUIT DE MISE À LA TERRE

(30) Priorität: 10.03.2020 AT 501972020
(43) Veröffentlichungstag der Anmeldung: 15.09.2021
(73) Patentinhaber: Sprecher Automation GmbH, 4020 Linz (AT)
(72) Erfinder: Druml, Gernot, 4212 Neumarkt im Mühlkreis (AT); Stachel, Philipp, 01069 Dresden (DE); Gebhard, Siegfried, 9062 Moosburg (AT)
(74) Vertreter: Hübscher & Partner Patentanwälte GmbH

(56) Entgegenhaltungen:
- AT-A2- 503 598
- DE-B3- 10 302 451
- JAMIL M ET AL: "Wave propagation in a faulty unbalanced EHV line", TENCON '98. 1998 IEEE REGION 10 INTERNATIONAL CONFERENCE ON GLOBAL CON NECTIVITY IN ENERGY, COMPUTER, COMMUNICATION AND CONTROL NEW DELHI, INDIA 17-19 DEC. 1998, PISCATAWAY, NJ, USA,IEEE, US, Bd. 2, 17. Dezember 1998 (1998-12-17), Seiten 428-431, XP010355514, DOI: 10.1109/TENCON.1998.798212 ISBN: 978-0-7803-4886-8

## Beschreibung

Die Erfindung bezieht sich auf ein Verfahren zur Messung der Erdschleifenimpedanz in zwei- oder mehrphasigen Nieder- oder Mittelspannungsnetzen mit nicht starr geerdetem Sternpunkt.

Aus dem Stand der Technik sind unterschiedliche Methoden bekannt, anhand des Quotienten aus der gemessenen Impedanz einer Leitung und der spezifischen Impedanz der Leitung pro Längeneinheit die Leitungslänge ausgehend von der Messstelle abzuschätzen. Diese Art der Entfernungsmessung eignet sich auch bei einem Kurzschluss zwischen zwei Leitern eines mehrphasigen Stromnetzes, da über die Messung von Strom und Spannung zwischen den Leitern die Impedanz einfach berechnet werden kann und der Fehlerstrom verglichen zum Strom nach der Fehlstelle hoch ist. Um eine möglichst exakte Fehlerortbestimmung zu ermöglichen, wird bei solchen Fehlerfällen vor der Impedanzmessung das Abklingen transienter Zustände abgewartet und/oder störende netzfrequenzfremde Signalanteile ausgefiltert.

Bei mehrphasigen Stromnetzen besteht im Falle eines Erdschlusses aber die Schwierigkeit, dass der Fehlerstrom je nach Art der Sternpunktbehandlung und der Art des Erdschlusses signifikant kleiner als die Stromstärken nach der Erdschluss-Fehlerstelle in Richtung Last sind und die Impedanz zwischen Leiter und Erde an der Erdschluss-Fehlerstelle unbekannt ist. Bisher wurde daher davon ausgegangen, dass eine Fehlerortung in diesem Fehlerfall nicht, oder nur unter bestimmten Randbedingungen mit sehr aufwändigen Verfahren, wie beispielsweise auf Basis von sich entlang der Leiter ausbreitenden Wanderwellen zuverlässig möglich ist. Aus der DE 103 02 451 B3 ist ein Verfahren zur Erkennung der Richtung eines Erdschlusses in nicht starr geerdeten Stromnetzen bekannt. Die Entfernung bis zum Ort des Fehlers wird aber nicht ermittelt.

Der Erfindung liegt somit die Aufgabe zugrunde, ein Verfahren der eingangs beschriebenen Art so auszugestalten, dass bei Ausbildung einer Erdschleife im Fall eines Erdschlusses einer Phase eines Stromnetzes mit nicht starr geerdetem Sternpunkt eine sehr rasche und einfach durchzuführende Messung der Erdschleifenimpedanz und damit eine zuverlässige Fehlerortbestimmung möglich ist.

Die Erfindung löst die gestellte Aufgabe dadurch, dass beim Erdschluss einer fehlerbehafteten Phase während der Aufladeschwingung die Strom- und Spannungswerte einer Phase über wenigstens eine Periode der Netzfrequenz mit wenigstens der doppelten Frequenz der Aufladeschwingung abgetastet und dass aus den abgetasteten Spannungs- oder Stromwerten die von der Netzfrequenz abweichenden Signalfrequenzen mit höchster Amplitude als Eigenfrequenz des von der Messstelle aus messbaren Serienschwingkreises bestimmt werden, wonach aus den Eigenfrequenzanteilen der Strom- und Spannungswerte der fehlerbehafteten Phase die Erdschleifenimpedanz ermittelt wird.

Der Erfindung liegt die Erkenntnis zugrunde, dass bei einem Erdschluss einer Phase eines Stromnetzes mit nicht starr geerdetem Sternpunkt der Aufladestrom zwischen den fehlerbehafteten und den fehlerunbehafteten Phasen im Vergleich zum Erdschlussstrom sehr hoch ist und dass sich aufgrund des Erdschlusses ein Serienschwingkreis mit einer von der Netzfrequenz abweichenden Eigenfrequenz ausbildet, der den Aufladevorgang der fehlerunbehafteten Phasen maßgeblich beeinflusst. Der hohe Erdschlussstrom kommt dadurch zustande, dass durch den Erdschluss das Potential des Sternpunktes, des zwei- oder mehrphasigen Mittelspannungsnetzes und somit auch alle Leiter der fehlerunbehafteten Phasen angehoben wird, wodurch die Leiter-Erdkapazitäten des gesamten Netzes dieser fehlerunbehafteten Phasen aufgeladen werden. Da diese Serienimpedanzen relativ klein sind werden die Leiter-Erdkapazitäten mit einem sehr großen Strom aufgeladen. Die zugehörige Aufladeschwingung weist einen über der Netzfrequenz liegenden Frequenzanteil auf, der der Eigenfrequenz des Serienschwingkreises entspricht. Diese Eigenfrequenz ist gegenüber den anderen Frequenzanteilen während des Einschwingvorganges des Serienschwingkreises, der auch als Aufladeschwingung bezeichnet wird, dominant und kann durch Abtastung der Spannungs- oder Stromwerte einer der Phasen bestimmt werden, indem eine für den Fachmann bekannte Frequenzmessung oder Transformation vom Zeit- in den Frequenzbereich durchgeführt wird. Beispielsweise kann eine Fourier-Transformation oder eine Hilbert-Transformation zum Einsatz kommen. Messungen an realen Mittelspannungsnetzen haben gezeigt, dass die Eigenfrequenz im Wesentlichen von der Netzausdehnung und der Kurzschlussimpendanz des Einspeisetransformators abhängt und typischerweise im Bereich von 75 - 6000 Hz liegen kann. Es empfiehlt sich daher, die Strom- und Spannungswerte mit einer Frequenz von 6 - 12 kHz abzutasten. Aufgrund der raschen Abklingzeit der Aufladeschwingung von wenigen Perioden der Netzfrequenz muss die Abtastung der Spannungs- oder Stromwerte unmittelbar nach dem Erdschlusseintritt erfolgen. Aufgrund der kurzen benötigten Messzeit von lediglich einer oder weniger Perioden der Netzfrequenz eignet sich das erfindungsgemäße Verfahren auch für die Impedanzbestimmung der Erdschleife im Fall von rasch wiederzündenden Erdschlüssen. Um den Signalanteil des Laststromes der fehlerunbehafteten Phasen dabei ausfiltern zu können, ist es notwendig, die Strom- und Spannungswerte einer Phase über wenigstens eine Periode der Netzfrequenz abzutasten, wobei es keine Rolle spielt, ob die Abtastung auf der fehlerbehafteten oder einer fehlerunbehafteten Phase erfolgt. Eine Abtastung an der fehlerbehafteten Phase hat aber den Vorteil, dass das an der fehlerbehafteten Phase, über die ja das gesamte Netz aufgeladen wird, die höchsten Spannungs- und Stromwerte auftreten, sodass eine zuverlässige Messung erfolgen kann. Die Eigenfrequenz des sich ausbildenden Serienschwingkreises kann dann als von der Netzfrequenz abweichende Frequenz mit der höchsten Amplitude im Frequenzspektrum ermittelt werden. Ist die Eigenfrequenz bekannt, können die Eigenfrequenzanteile der Strom- und Spannungswerte der fehlerbehafteten Phase, beispielsweise mit Hilfe einer Fourier-Transformation bestimmt und daraus die Impedanz des Serienschwingkreises als Erdschleifenimpedanz ermittelt werden. Durch die Messung der Erdschleifenimpedanz über die Eigenfrequenzanteile der Strom- und Spannungswerte der Erdschleife kann das erfindungsgemäße Verfahren somit bei nicht starr geerdetem, also insbesondere bei hochohmig, induktiv oder nicht geerdetem Sternpunkt angewandt werden. In all diesen Fällen sind die Ströme über die Erdschluss-Fehlerstelle bedeutend kleiner als die Lastströme nach der Erdschluss-Fehlerstelle. Besonders gute Messergebnisse können bei Erdschlussübergangswiderständen von bis zu 500 Ohm erreicht werden.

Um die Messgenauigkeit zu erhöhen, wird vorgeschlagen, dass die abgetasteten Spannungs- oder Stromwerte in eine Reihe gedämpfter Schwingungsanteile aufgelöst werden, von denen der von der Netzfrequenz abweichende Schwingungsanteil mit höchster Amplitude als Eigenfrequenzanteil herangezogen wird. Da die Amplitude der Aufladeschwingung rasch abklingt, liefert beispielsweise eine Fouriertransformation zur Bestimmung der Frequenzanteile ungenaue Ergebnisse, da diese Transformation für gleichbleibende Amplituden ohne Dämpfung definiert ist. Darüber hinaus kommen zur Erdschlusskompensation induktiv geerdete Sternpunkte zum Einsatz, wodurch sich beim Zünden des Erdschlusses ein zusätzlicher gedämpften Parallelschwingkreis mit den Leiterkapazitäten der fehlerunbehafteten Phasen ausbildet. Dabei wird die Induktivität der Sternpunkterdung so an die Leiterkapazitäten angepasst, dass im eingeschwungenen Zustand möglichst kein netzfrequenter Strom über die Erdschluss-Fehlerstelle fließt. Damit kann sich aber im Falle eines Zündens des Erdschlusses im Spannungsmaximum der Leiter-Erde Spannung ein bedeutender Gleichstromanteil in den für die Impedanzbestimmung herangezogenen Strom- und Spannungswerten ergeben, der die Abbildung im Frequenzbereich verfälscht. Obwohl grundsätzlich auch in diesem Fall eine Fourier-Transformation zur Bestimmung der Frequenzanteile herangezogen werden kann, wenn man entsprechende Fehler in der Impedanzbestimmung in Kauf nimmt, ergeben sich deutlich exaktere Messbedingungen, wenn die abgetasteten Spannungs- und Stromwerte in eine Reihe gedämpfter Schwingungsanteile, beispielsweise durch Parameterschätzung oder anhand der Prony - Methoden aufgelöst werden, sodass die abklingenden Gleichstromanteile berücksichtigt werden können.

Um aus der Erdschleifenimpedanz die Entfernung der Erdschluss-Fehlerstelle zur Messstelle zu bestimmen, wird vorgeschlagen, dass aus dem Blindanteil der Erdschleifenimpedanz bei Eigenfrequenz des Serienschwingkreises der Blindanteil der Erdschleifenimpedanz bei Netzfrequenz ermittelt wird, woraus die Erdschlussentfernung anhand bekannter leitungslängenabhängiger Leitungsimpedanzen bestimmt wird. Nachdem die Impedanz eines etwaigen Lichtbogens an der Erdschluss-Fehlerstelle genauso unbekannt wie der Erdschlussübergangswiderstand ist und diese in erster Näherung durch ohmsche Widerstände nachgebildet werden, werden diese für die Entfernungsabschätzung durch die Reduktion auf den induktiven Blindanteil der Erdschleifenimpedanz unterdrückt. Da die ermittelten Blindanteile der Erdschleifenimpedanz proportional zur Eigenfrequenz sind, können diese Blindanteile der Erdschleifenimpedanz durch eine Lineartransformation für die Netzfrequenz ermittelt werden. Neben der Netzfrequenz hängt die Impedanz zusätzlich von den Materialeigenschaften, der geometrischen Anordnung und der Länge des Leiters ab. Sind also die Materialeigenschaften bekannt, kann die Länge bis zur Erdschluss-Fehlerstelle aus der lineartransformierten Erdschleifenimpedanz für die Netzfrequenz aus der spezifischen Impedanz pro Leiterlängeneinheit rückermittelt werden, womit eine hinreichend genaue Fehlerortbestimmung auch im Fall von Erdschlüssen in zwei und mehrphasigen Nieder- oder Mittelspannungsnetzen mit nicht starr geerdetem Sternpunkt ermöglicht wird.

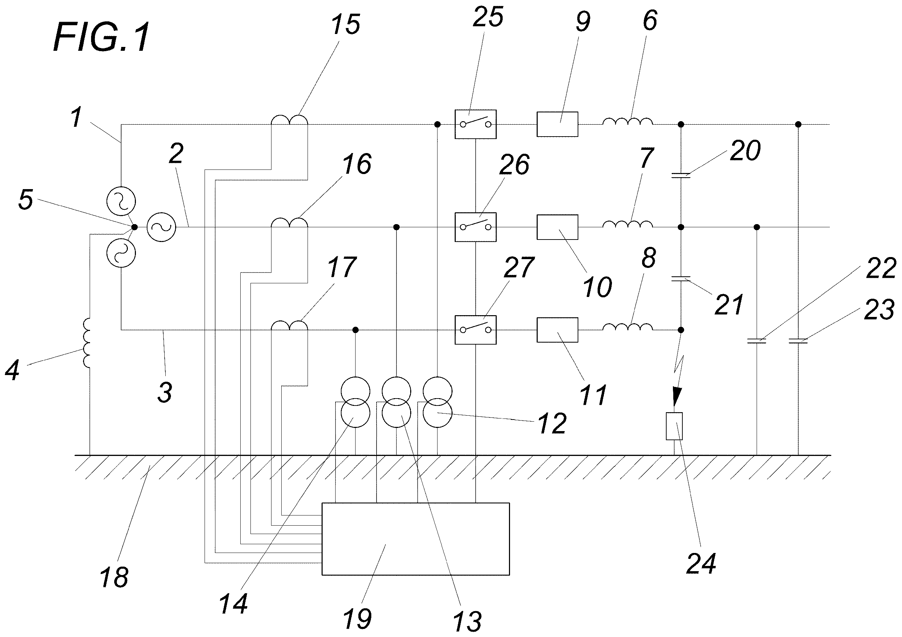

In der Zeichnung ist der Erfindungsgegenstand beispielsweise dargestellt. Es zeigen
- Fig. 1: ein schematisches Blockschaltbild eines induktiv geerdeten Drehstromnetzwerks mit Erdschluss-Distanzrelais und
- Fig. 2: den zeitlichen Spannungs- bzw. Stromverlauf der fehlerbehafteten Phase vor und während des Erdschlusses.

Ein induktiv geerdetes Drehstromnetz mit Erdschluss-Distanzrelais zur Durchführung des erfindungsgemäßen Verfahrens umfasst drei Phasen 1, 2, 3, die über eine Induktivität 4 am Sternpunkt eines Einspeisetransformators 5 geerdet sind. Die Impedanz jeder Phase 1, 2, 3 lässt sich durch einen induktiven Anteil 6, 7, 8 und einen ohmschen Anteil 9, 10, 11 darstellen. Spannungswandler 12, 13, 14 und Stromwandler 15, 16, 17 erlauben die Bestimmung der Spannung zwischen den einzelnen Phasen 1, 2, 3 und der Erde 18 bzw. die Bestimmung des Stromes in den einzelnen Phasen 1, 2, 3 und können mit einer vorgegebenen Abtastrate, die wenigstens dem Doppelten der Eigenfrequenz eines sich im Erdschlussfall ausbildenden Serienschwingkreises abgetastet und über ein Erdschluss-Distanzrelais 19 als Strom- und Spannungswerte ausgelesen werden. Die Phasen 1, 2, 3 bilden untereinander Leiterkapazitäten 20, 21 und zur Erde Erdkapazitäten 22, 23 aus. Im gezeigten Beispiel findet über die Phase 3 ein Erdschluss statt, wodurch sich ein in erster Näherung ohmscher Erdschlussübergangswiderstand 24 zur Erde 18 ausbildet. Durch den Erdschluss kommt es zu einer Aufladeschwingung, da der Sternpunkt des Einspeisetransformators 5 des mehrphasigen Stromnetzes angehoben wird. Während dieser Aufladeschwingung werden die Strom- und Spannungswerte einer Phase 1, 2, 3, vorzugsweise der fehlerbehafteten Phase 3 vom Erdschluss-Distanzrelais 19 aufgezeichnet und nach wenigstens einer Periode der Netzfrequenz ausgewertet. Zu diesem Zweck werden über eine der oben beschriebenen Transformationen, beispielsweise mit Hilfe der Prony - Methoden, aus den aufgezeichneten Strom- oder Spannungswerten die von der Netzfrequenz abweichenden Signalfrequenzen mit höchster Amplitude als Eigenfrequenz des sich von der Messstelle aus ausbildenden Serienschwingkreises bestimmt. Danach wird aus den Eigenfrequenzanteilen der Strom- und Spannungswerte der fehlerbehafteten Phase 3 die Impedanz der fehlerbehafteten Phase 3 von der Messstelle bis zur Erdschluss-Fehlerstelle als Erdschleifenimpedanz ermittelt. Die Erdschleifenimpedanz kann danach direkt am Erdschluss-Distanzrelais 19 oder über eine nicht näher dargestellte Steuerwarte mit vorgegebenen Impedanzwerten verglichen und in Abhängigkeit der Abweichung von diesen vorgegebenen Werten signalisiert oder wahlweise einer oder alle Leistungsschalter 25, 26, 27 abgeschaltet werden. Im Fall von gelöschten Netzen bzw. bei einem 50 Hz-Stromanteil von weniger als 30 A über die Fehlerstelle genügt es allerdings, den Erdschluss lediglich anzuzeigen, und mit Hilfe des erfindungsgemäßen Verfahrens eine rasche Fehlerortung zu ermöglichen. Darüber hinaus können zur Entfernungsbestimmung von der Messstelle zur Erdschluss-Fehlerstelle entlang der fehlerbehafteten Phase 3 aus der Erdschleifenimpedanz die Blindanteile ermittelt und mit bekannten Blindanteilen je Leitungssegment der Phase 3 nach bekannten Verfahren die Entfernung zur Erdschluss-Fehlerstelle ermittelt werden.

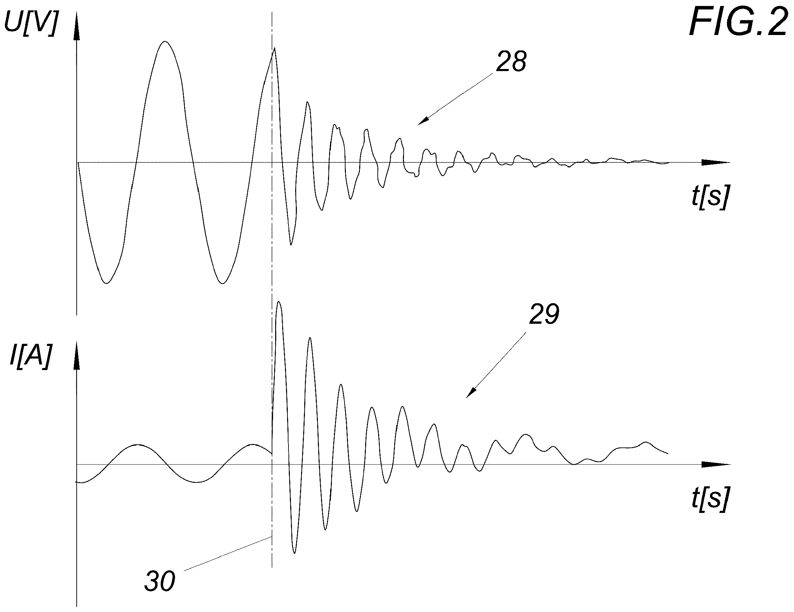

Fig. 2 zeigt schematisch den über die Zeit aufgetragenen Spannungsverlauf 28 zwischen fehlerbehafteter Phase 3 und Erde 18 in Volt und den ebenfalls über die Zeit aufgetragenen Stromverlauf 29 der fehlerbehafteten Phase 3 in Ampere. Die Linie 30 markiert in Fig. 2 den Zeitpunkt des Erdschlussbeginns, der zu einer Abnahme der Spannung und kurzfristigen Zunahme des Stromes in der fehlerbehafteten Phase 3 zufolge der beschriebenen Aufladeschwingung führt. Die ab diesem Zeitpunkt ersichtliche Änderung der Wellenform kommt durch die Überlagerung der Netzfrequenz mit den Eigenfrequenzen des beschriebenen Serienschwingkreises zustande. Die Spannung und der Strom der im Vergleich zur Netzfrequenz höherfrequenten abklingenden Aufladeschwingung können ab dem Zeitpunkt des Erdschlussbeginns zur Berechnung der Erdschleifenimpedanz bei der Eigenfrequenz des sich ausbildenden Serienschwingkreises und im Weiteren bei Netzfrequenz verwendet werden.

## Patentansprüche

1. Verfahren zur Messung der Erdschleifenimpedanz in zwei- oder mehrphasigen Nieder- oder Mittelspannungsnetzen mit nicht starr geerdetem Sternpunkt (5), **dadurch gekennzeichnet, dass** beim Erdschluss einer fehlerbehafteten Phase (3) während der Aufladeschwingung die Strom- und Spannungswerte einer Phase (1, 2, 3) über wenigstens eine Periode der Netzfrequenz mit wenigstens der doppelten Frequenz der Aufladeschwingung abgetastet und dass aus den abgetasteten Spannungs- oder Stromwerten die von der Netzfrequenz abweichenden Signalfrequenzen mit höchster Amplitude als Eigenfrequenz des von der Messstelle aus messbaren Serienschwingkreises bestimmt werden, wonach aus den Eigenfrequenzanteilen der Strom- und Spannungswerte der fehlerbehafteten Phase (3) die Erdschleifenimpedanz ermittelt wird.

2. Verfahren nach Anspruch 1, **dadurch gekennzeichnet, dass** die abgetasteten Spannungs- oder Stromwerte in eine Reihe gedämpfter Schwingungsanteile aufgelöst werden, von denen der von der Netzfrequenz abweichende Schwingungsanteilmit höchster Amplitude als Eigenfrequenzanteil herangezogen wird.

3. Verfahren nach Anspruch 1 oder 2, **dadurch gekennzeichnet, dass** aus dem Blindanteil der Erdschleifenimpedanz bei Eigenfrequenz des Schwingkreises der Blindanteil der Erdschleifenimpedanz bei Netzfrequenz ermittelt wird, woraus die Erdschlussentfernung anhand bekannter leitungslängenabhängiger Leitungsimpedanzen bestimmt wird.

## Claims

1. Method for measuring the earth loop impedance in two-phase or multi-phase low-voltage or medium-voltage networks having a non-rigidly earthed neutral point (5), **characterised in that**, in the event of an earth fault of a defective phase (3) during the charging oscillation, the current and voltage values of one phase (1, 2, 3) are sampled over at least one period of the mains frequency at at least twice the frequency of the charging oscillation, and **in that** the signal frequencies with the highest amplitude which deviate from the mains frequency are determined from the sampled voltage or current values as the natural frequency of the series oscillating circuit which can be measured from the measuring point, whereupon the earth loop impedance is ascertained from the natural frequency components of the current and voltage values of the defective phase (3).

2. Method as claimed in claim 1, **characterised in that** the sampled voltage or current values are resolved into a series of damped oscillation components, of which the oscillation component with the highest amplitude which deviates from the mains frequency is used as the natural frequency component.

3. Method as claimed in claim 1 or 2, **characterised in that** the reactive component of the earth loop impedance at the natural frequency of the oscillating circuit is used for ascertaining the reactive component of the earth loop impedance at the mains frequency, from which the earth fault distance is determined on the basis of known line length-dependent line impedances.

## Revendications

1. Procédé pour mesurer l'impédance de la boucle de terre sur des réseaux à basse ou moyenne tension biphasés ou polyphasés avec un point neutre (5) non relié à la terre de manière rigide, **caractérisé en ce que**, lors de la mise à la terre d'une phase défectueuse (3), pendant l'oscillation de charge, les valeurs d'intensité et de tension d'une phase (1, 2, 3) sont échantillonnées sur au moins une période de la fréquence du réseau avec au moins le double de la fréquence de l'oscillation de charge et qu'à partir des valeurs de tension ou d'intensité échantillonnées, les fréquences de signal divergeant de la fréquence du réseau sont déterminées avec l'amplitude maximale comme fréquence propre du point de mesure du circuit oscillant série mesurable, après quoi l'impédance de boucle de terre est définie à partir des composantes de fréquence propre des valeurs d'intensité et de tension de la phase défectueuse (3).

2. Procédé selon la revendication 1, **caractérisé en ce que** les valeurs de tension ou d'intensité échantillonnées sont fractionnées en une série de composantes d'oscillation amorties dont la composante d'oscillation divergeant de la fréquence du réseau est déduite avec l'amplitude maximale comme composante de fréquence propre.

3. Procédé selon la revendication 1 ou 2, **caractérisé en ce que** la composante réactive de l'impédance de la boucle de terre à la fréquence du réseau est définie à partir de la composante réactive de l'impédance de la boucle de terre à la fréquence propre du circuit oscillant, à partir de quoi la distance du défaut de terre est déterminée à l'aide d'impédances de ligne en fonction de la longueur de ligne connues.
